# FASCICULE DE BREVET EUROPEEN

(11) **EP 3 964 296 B1**
(45) Date de publication et mention de la délivrance du brevet: **04.11.2026**
(21) Numéro de dépôt: 21194625.6
(22) Date de dépôt: 02.09.2021
(51) Int. Cl.: B03C 7/00, B03C 7/12

(54) **PROCÉDÉ DE CONCEPTION D'UN DISPOSITIF DE SÉPARATION ÉLECTROSTATIQUE D'UN MÉLANGE DE GRANULES DE MATÉRIAUX DIFFÉRENTS ET DISPOSITIFS ASSOCIÉS**
VERFAHREN ZUR PLANUNG EINER VORRICHTUNG ZUR ELEKTROSTATISCHEN TRENNUNG EINES GRANULATGEMISCHS AUS VERSCHIEDENEN MATERIALIEN UND ENTSPRECHENDE VORRICHTUNGEN
METHOD FOR DESIGNING A DEVICE FOR ELECTROSTATIC SEPARATION OF A MIXTURE OF GRANULES OF DIFFERENT MATERIALS AND ASSOCIATED DEVICES

(30) Priorité: 03.09.2020 FR 2008934
(43) Date de publication de la demande: 09.03.2022
(73) Titulaire: SKYTECH, 27940 Le Val d'Hazey (FR)
(72) Inventeur: SOMMEN, Pierre, 27120 PACY-SUR-EURE (FR)
(74) Mandataire: Lavoix

(56) Documents cités:
- WO-A1-2007/053089
- US-A- 6 011 229
- US-A1- 2016 038 950
- US-B1- 6 681 938

## Description

La présente invention concerne un procédé de conception d'une partie d'un dispositif de séparation électrostatique d'un mélange de granules de matériaux différents. La présente invention se rapporte aussi à un ensemble de conception propre à concevoir une partie d'un dispositif de séparation électrostatique.

Des dispositifs de séparation électrostatique sont déjà utilisés pour trier des matériaux granulaires mélangés provenant, par exemple, du broyage des déchets industriels. Généralement, la majeure partie des matériaux à séparer est constituée de matériaux isolants électriquement, et notamment de matériaux plastiques.

Par exemple, le recyclage de déchets électriques et/ou électroniques implique de séparer les différents composants avant de valoriser les matériaux obtenus. Il est souhaitable qu'une telle séparation soit la plus efficace possible pour obtenir une qualité sensiblement constante des matériaux recyclés.

Lorsque les matériaux à séparer présentent des densités égales ou très proches, les procédés de séparation basés sur la gravité sont trop imprécis et ne permettent pas d'obtenir des séparations satisfaisantes.

Pour cela, il est connu une technique consistant à broyer les matériaux isolants pour en faire des granules et de les séparer par effet électrostatique.

Dans une première étape, les granules sont chargés par effet triboélectrique dans un dispositif à vibration ou rotatif. Dans une deuxième étape, les granules chargés sont convoyés vers un dispositif de tri électrostatique dans lequel ils sont séparés par un champ électrique. A cette fin, les granules sont injectés par le haut du dispositif de tri où ils tombent entre deux électrodes.

Les granules chargés positivement sont attirés par l'anode (l'électrode négative), alors que les granules chargés négativement sont attirés par la cathode (l'électrode positive). Les granules ainsi déviés dans leur chute sont séparés et tombent dans une zone de collecte comprenant des collecteurs différents, disposés en bas du dispositif et au droit des électrodes.

Dans la zone de collecte, le nombre de compartiments varie afin d'optimiser la pureté recherchée. La matière la plus pure se trouve dans les compartiments situés aux extrémités de la zone de collecte, qui reçoivent les granules les plus fortement déviés, et la matière la plus mélangée se trouve dans les compartiments les plus centraux.

Il est courant de constater dans les séparateurs actuels que le taux de matière non séparée est compris entre 35% et 50%, c'est-à-dire que seulement 50% à 65% de matière est séparée en une seule passe avec un taux de pureté requis de, par exemple, 95%.

Des exemples de tels systèmes sont notamment divulgués dans les documents US 6 681 938 B1, US 6 011 229 A, US 2016/038950 A1 et WO 2017/053089 A1.

Il existe donc un besoin pour un procédé permettant d'obtenir ou de régler au moins une partie du dispositif de séparation électrostatique pour améliorer la performance du dispositif de séparation.

A cet effet, la description décrit un procédé de conception d'une partie d'un dispositif de séparation électrostatique d'un mélange de granules de matériaux différents, le procédé étant selon la revendication 1.

Selon des modes de réalisation particuliers, le procédé de conception présente une ou plusieurs des caractéristiques des revendications 2 ou 3, prise(s) isolément ou selon toutes les combinaisons techniquement possibles.

La description porte aussi sur un ensemble de conception selon la revendication 4.

Dans la présente description, l'expression « propre à » signifie indifféremment « adapté pour », « adapté à » ou « configuré pour ».

Des caractéristiques et avantages de l'invention apparaîtront à la lecture de la description qui va suivre, donnée uniquement à titre d'exemple non limitatif, et faite en référence aux dessins annexés, sur lesquels :
- figure 1, une représentation schématique d'un ensemble de conception et d'un produit programme d'ordinateur,
- figure 2, un ordinogramme d'un exemple de mise en œuvre d'un procédé de conception par l'ensemble de conception de la figure 1, et
- figure 3, une représentation schématique d'un dispositif de séparation électrostatique.

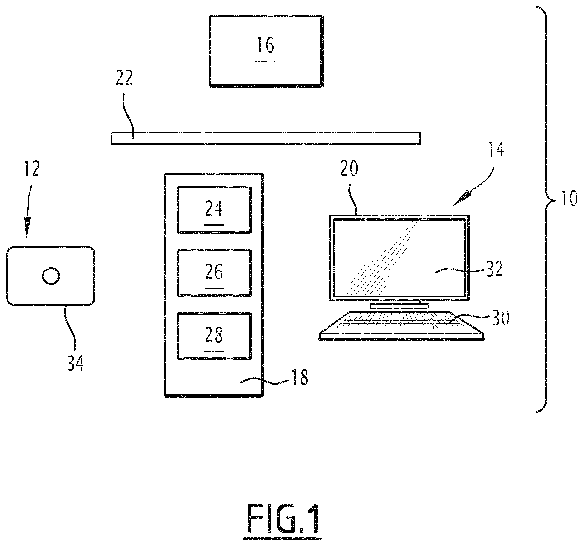

Un ensemble de conception 10 et un produit programme d'ordinateur 12 sont représentés sur la figure 1.

L'interaction entre l'ensemble de conception 10 et le produit programme d'ordinateur 12 permet la mise en œuvre d'un procédé de conception d'une partie d'un dispositif de séparation électrostatique d'un mélange de granules de matériaux différents. Le procédé de conception est ainsi un procédé mis en œuvre par ordinateur.

L'ensemble de conception 10 comporte un système 14 et une unité de fabrication 16.

Le système 14 est un ordinateur de bureau. En variante, le système 14 est un ordinateur monté sur un rack, un ordinateur portable, une tablette, un assistant numérique personnel (PDA) ou un smartphone.

Dans le cas de la figure 1, le système 14 comprend un calculateur 18, une interface utilisateur 20 et un dispositif de communication 22.

Le calculateur 18 est un circuit électronique conçu pour manipuler et/ou transformer des données représentées par des quantités électroniques ou physiques dans des registres du système 14 et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 18 comprend un processeur monocœur ou multicœurs (tel qu'une unité de traitement centrale (CPU), une unité de traitement graphique (GPU), un microcontrôleur et un processeur de signal numérique (DSP)), un circuit logique programmable (comme un circuit intégré spécifique à une application (ASIC), un réseau de portes programmables *in situ* (FPGA), un dispositif logique programmable (PLD) et des réseaux logiques programmables (PLA)), une machine à états, une porte logique et des composants matériels discrets.

Le calculateur 18 comprend une unité de traitement de données 24 adaptée pour traiter des données, notamment en effectuant des calculs, des mémoires 26 adaptées à stocker des données et un lecteur 28 adapté à lire un support lisible par ordinateur.

L'interface utilisateur 20 comprend un dispositif d'entrée 30 et un dispositif de sortie 32.

Le dispositif d'entrée 30 est un dispositif permettant à l'utilisateur du système 14 de saisir sur le système 14 des informations ou des commandes.

Sur la figure 1, le dispositif d'entrée 30 est un clavier. En variante, le dispositif d'entrée 30 est un périphérique de pointage (tel qu'une souris, un pavé tactile et une tablette graphique), un dispositif de reconnaissance vocale, un oculomètre ou un dispositif haptique (analyse des mouvements).

Le dispositif de sortie 32 est une interface utilisateur graphique, c'est-à-dire une unité d'affichage conçue pour fournir des informations à l'utilisateur du système 14.

Sur la figure 1, le dispositif de sortie 32 est un écran d'affichage permettant une présentation visuelle de la sortie. Dans d'autres modes de réalisation, le dispositif de sortie 32 est une imprimante, une unité d'affichage augmenté et/ou virtuel, un haut-parleur ou un autre dispositif générateur de son pour présenter la sortie sous forme sonore, une unité produisant des vibrations et/ou des odeurs ou une unité adaptée à produire un signal électrique.

Dans un mode de réalisation spécifique, le dispositif d'entrée 30 et le dispositif de sortie 32 sont le même composant formant des interfaces homme-machine, tel qu'un écran interactif.

Le dispositif de communication 22 permet une communication unidirectionnelle ou bidirectionnelle entre les composants du système 14. Par exemple, le dispositif de communication 22 est un système de communication par bus ou une interface d'entrée / sortie.

La présence du dispositif de communication 22 permet que, dans certains modes de réalisation, les composants du calculateur 18 soient distants les uns des autres.

Le produit programme informatique 12 comprend un support lisible par ordinateur 34.

Le support lisible par ordinateur 34 est un dispositif tangible lisible par le lecteur 28 du calculateur 18.

Notamment, le support lisible par ordinateur 34 n'est pas un signal transitoire en soi, tels que des ondes radio ou d'autres ondes électromagnétiques à propagation libre, telles que des impulsions lumineuses ou des signaux électroniques.

Un tel support de stockage lisible par ordinateur 34 est, par exemple, un dispositif de stockage électronique, un dispositif de stockage magnétique, un dispositif de stockage optique, un dispositif de stockage électromagnétique, un dispositif de stockage à semi-conducteur ou toute combinaison de ceux-ci.

En tant que liste non exhaustive d'exemples plus spécifiques, le support de stockage lisible par ordinateur 34 est un dispositif codé mécaniquement, tel que des cartes perforées ou des structures en relief dans une gorge, une disquette, un disque dur, une mémoire morte (ROM), une mémoire vive (RAM), une mémoire effaçable programmable en lecture seule (EROM), une mémoire effaçable électriquement et lisible (EEPROM), un disque magnéto-optique, une mémoire vive statique (SRAM), un disque compact (CD-ROM), un disque numérique polyvalent (DVD), une clé USB, un disque souple, une mémoire flash, un disque à semi-conducteur (SSD) ou une carte PC telle qu'une carte mémoire PCMCIA.

Un programme d'ordinateur est stocké sur le support de stockage lisible par ordinateur 34. Le programme d'ordinateur comprend une ou plusieurs séquences d'instructions de programme mémorisées.

De telles instructions de programme, lorsqu'elles sont exécutées par l'unité de traitement de données 24, entraînent l'exécution d'étapes du procédé de conception.

Par exemple, la forme des instructions de programme est une forme de code source, une forme exécutable par ordinateur ou toute forme intermédiaire entre un code source et une forme exécutable par ordinateur, telle que la forme résultant de la conversion du code source via un interpréteur, un assembleur, un compilateur, un éditeur de liens ou un localisateur. En variante, les instructions de programme sont un microcode, des instructions firmware, des données de définition d'état, des données de configuration pour circuit intégré (par exemple du VHDL) ou un code objet.

Les instructions de programme sont écrites dans n'importe quelle combinaison d'un ou de plusieurs langages, par exemple un langage de programmation orienté objet (FORTRAN, C++, JAVA, HTML), un langage de programmation procédural (langage C par exemple).

Alternativement, les instructions du programme sont téléchargées depuis une source externe via un réseau, comme c'est notamment le cas pour les applications. Dans ce cas, le produit programme d'ordinateur comprend un support de données lisible par ordinateur sur lequel sont stockées les instructions de programme ou un signal de support de données sur lequel sont codées les instructions de programme.

Dans chaque cas, le produit programme d'ordinateur 12 comprend des instructions qui peuvent être chargées dans l'unité de traitement de données 24 et adaptées pour provoquer l'exécution du procédé de conception lorsqu'elles sont exécutées par l'unité de traitement de données 24. Selon les modes de réalisation, l'exécution est entièrement ou partiellement réalisée soit sur le système 14, c'est-à-dire un ordinateur unique, soit dans un système distribué entre plusieurs ordinateurs (notamment via l'utilisation de l'informatique en nuage).

L'unité de fabrication 16 est propre à fabriquer une partie d'un dispositif de séparation électrostatique sur la base d'un jeu de paramètres bien choisi.

Des exemples de jeu de paramètres correspondants sont donnés dans la suite de la description.

Selon une variante, l'unité de fabrication 16 est propre à fabriquer tous les parties d'un dispositif de séparation électrostatique avec des paramètres additionnels relatifs aux autres parties du dispositif.

Un exemple de telle partie est la zone de collecte.

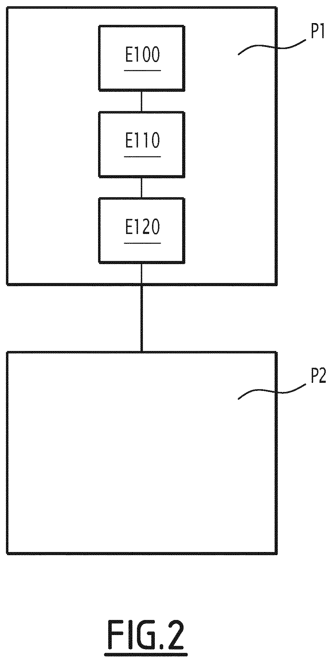

Le fonctionnement de l'ensemble de conception 10 est maintenant décrit en référence à la figure 2 qui est un ordinogramme illustrant un exemple de mise en œuvre du procédé de conception.

Le procédé de conception vise à concevoir une partie d'un dispositif de séparation électrostatique d'un mélange de granules de matériaux différents présentant des propriétés améliorées.

Le procédé de conception est mis en œuvre par ordinateur de sorte que le procédé peut être qualifié de procédé assisté par ordinateur. Un tel procédé est souvent désigné sous l'appellation procédé de CAO ou procédé de CAD, l'abréviation de CAO renvoyant à la dénomination française et l'abréviation de CAD renvoyant à la dénomination anglaise de « Computer Aided Design ».

Le procédé de conception correspond également à un procédé de mise au point d'une partie d'un dispositif de séparation électrostatique d'un mélange de granules de matériaux différents.

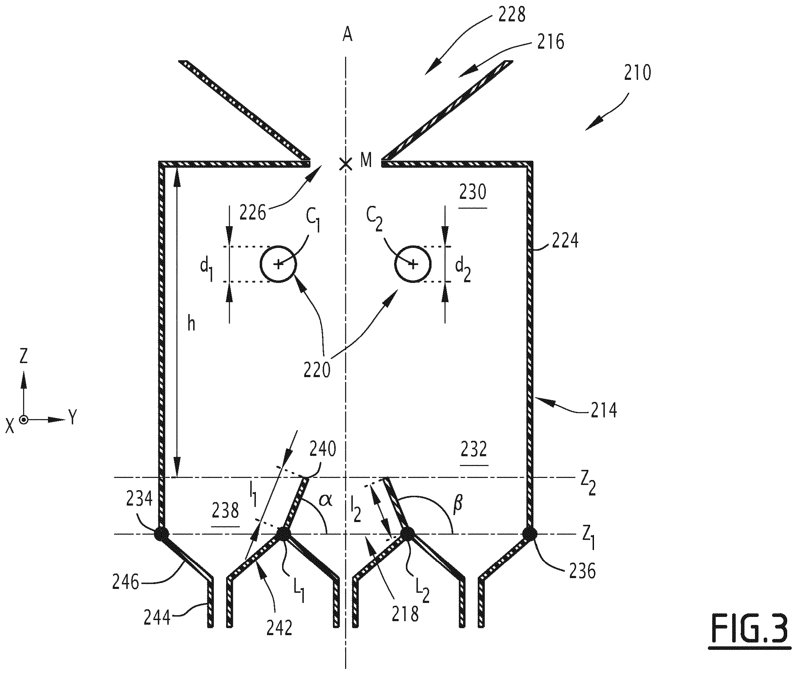

Le dispositif de séparation 210 est représenté sur la figure 3. Le dispositif 210 est adapté pour séparer un mélange de granules.

Le dispositif 210 est décrit en référence à une direction d'élévation Z, orientée selon la gravité, ainsi qu'une direction longitudinale X et une direction transversale Y perpendiculaires entre elles et à la direction d'élévation Z.

Le dispositif 210 comprend une chambre de séparation 214, une zone de collecte des granules 218, des électrodes 220 et un système de génération d'une différence de potentiel non représenté sur la figure 3 dans un souci de clarté de la figure.

Par l'expression « séparer le mélange de granules », il est entendu que le dispositif 210 est adapté pour trier au moins une partie des granules composant le mélange selon une composition desdits granules.

Le mélange de granules comprend des granules d'au moins deux matériaux différents.

Par le terme « granule », il est entendu une particule présentant une forme sensiblement compacte, composée d'au moins un matériau. Un granule présente des dimensions caractéristiques millimétriques. Par exemple, chaque granule présente des longueurs, mesurées selon chacune des directions, comprises entre 1 millimètre (mm) et 16 mm.

Le mélange comprend notamment des granules de formes variées et de dimensions variées, par exemple selon une distribution normale de taille centrée autour des dimensions caractéristiques précédentes.

Par l'expression « des granules d'au moins deux matériaux différents », il est entendu que le mélange comprend, par exemple, au moins une première population de granules comprenant majoritairement un premier matériau et une deuxième population de granules comprenant majoritairement un deuxième matériau, le deuxième matériau étant distinct du premier matériau.

Par l'expression « majoritairement », il est entendu que chaque granule de la première population comprend par exemple au moins 90% en masse du premier matériau ou que chaque granule de la deuxième population comprend au moins 90% en masse du deuxième matériau.

Suivant l'exemple proposé, le premier matériau et le deuxième matériau sont des matériaux isolants électriquement, notamment des matériaux plastiques.

Par exemple, le premier matériau et le deuxième matériau sont choisis dans le groupe constitué du polypropylène, du polystyrène, du polyamide, de l'acrylonitrile butadiène styrène et du polyéthylène.

Le mélange de granules est, par exemple, obtenu par broyage, en particulier de déchets, plus spécifiquement de déchets industriels, issus d'équipement électriques et/ou électroniques ou de véhicule hors d'usage.

La chambre de séparation 214 est un compartiment adapté pour contenir et isoler le mélange pendant la séparation des granules.

Notamment, la chambre de séparation 214 est adaptée pour protéger le mélange de granules des variations de température, de pression, d'humidité et de champ électrique à l'extérieur de la chambre, au cours de la séparation.

La chambre de séparation 214 comprend des parois 224 qui délimitent un volume intérieur et définissent une entrée 226.

La chambre de séparation 214 comprend un dispositif d'introduction 228 des granules par l'entrée 226.

La chambre de séparation 214 contient la zone de collecte 218.

La chambre de séparation 214 s'étend selon un axe central A, sensiblement parallèle à la direction d'élévation Z, passant par l'entrée 226 et la zone de collecte 218.

La chambre de séparation 214 comprend une partie haute 230 et une partie basse 232, relativement à la gravité.

La partie haute 230 est, par exemple, la partie de la chambre de séparation 214 s'étendant au-dessus des électrodes 220, selon la direction d'élévation Z.

La partie basse 232 est, par exemple, la partie de la chambre de séparation 214 s'étendant en dessous des électrodes 220, selon la direction d'élévation Z.

Il est à noter que la partie de la chambre de séparation 214 qui n'est pas dans la zone de collecte 218 dont l'extrémité est matérialisée par une ligne Z2 est la zone de tri ZT.

L'entrée 226 est une ouverture dans les parois 224 située dans la partie haute 230 de la chambre de séparation 214, relativement à la direction d'élévation Z.

L'entrée 226 est munie du dispositif d'introduction 228.

Le dispositif d'introduction 228 est adapté pour introduire les granules dans la chambre de séparation 214 à travers l'entrée 226.

Le dispositif d'introduction 288 est, selon l'exemple représenté, une trémie vibrante, comprenant des flancs de trémie et au moins un actionneur.

Les flancs de trémie définissent un espace interne tronconique, d'axe parallèle à la direction d'élévation Z et convergent vers l'entrée 226 de la chambre de séparation 214.

Le ou les actionneurs sont des moteurs vibrants, agencés pour faire vibrer les flancs, pour faciliter l'écoulement des granules vers l'entrée 226.

Selon d'autres modes de réalisation, le dispositif d'introduction 228 comprend un convoyeur à bande ou une table vibrante.

La zone de collecte 218 est adaptée pour recevoir les granules après la traversée de la chambre de séparation 214 par les granules.

La zone de collecte 218 est contenue dans le volume intérieur, et située dans la partie basse 232 de la chambre de séparation 214.

La zone de collecte 218 s'étend ainsi entre une première extrémité 234 et une deuxième extrémité 236.

Les deux extrémités 234 et 236 de la zone de collecte 218 sont alignés le long d'une droite notée Z1 sur la figure 3.

La zone de collecte 218 comprend une pluralité de compartiments alignés le long de la partie basse 232 de la chambre de séparation 214, selon la direction transversale Y.

Les compartiments sont des espaces de réception des granules, sensiblement parallélépipédiques, alignés le long de la direction transversale Y et séparés les uns des autres par des diviseurs 240 ou volets qui font partie de la zone de collecte 218.

Chaque compartiment est agencé pour recevoir une partie des granules de la chambre de séparation 214.

La partie des granules reçue par le compartiment 238 dépend d'une déviation des granules dans la chambre de séparation 214 et d'une position du compartiment 238 dans la partie basse 232 de la chambre de séparation 214.

Avantageusement, chaque compartiment 238 comprend un dispositif d'évacuation 242 des granules, adapté pour extraire continument les granules reçus par le compartiment 238.

Les dispositifs d'évacuation 242 permettent au dispositif de séparation de fonctionner en continu.

Chaque dispositif d'évacuation 242 comprend, par exemple, un tuyau débouchant dans le fond du compartiment 238 par un évasement 246, ainsi qu'un organe de circulation (non représenté) des granules dans le tuyau 244, comme par exemple une pompe.

Les électrodes 220 sont adaptées pour générer un champ électrique au niveau de l'axe central A.

Le champ électrique généré par les électrodes 220 permet de dévier les granules traversant la chambre de séparation 214.

L'anode est une électrode adaptée pour recevoir un potentiel électrique imposé par le système de génération.

La cathode est également une électrode adaptée pour recevoir un potentiel électrique imposé par le système de génération, le potentiel électrique de la cathode étant supérieur au potentiel électrique de l'anode.

La cathode est disposée d'un même côté de l'axe central A, ce côté est opposé au côté de l'anode. La cathode est donc positionnée de manière à être en regard de l'anode.

Le système de génération est adapté pour générer une différence de potentiel électrique entre l'anode et la cathode, de façon à former dans la chambre de séparation 214 un champ électrique dérivant de des différences de potentiel.

Le champ électrique formé a une intensité suffisante pour dévier les granules présentant une charge de surface et les diriger vers différents compartiments 238 de la zone de collecte 18, pour mettre en œuvre la séparation.

Ainsi, le système de génération est adapté pour dévier les granules présentant une charge de surface positive vers l'anode et les granules présentant une charge de surface négative vers la cathode.

En référence à la figure 2, le procédé de conception comporte deux phases P1 et P2, une phase de d'optimisation P1 et une phase de fabrication P2.

La phase d'optimisation P1 vise à optimiser au moins un paramètre caractérisant la zone de collecte 218.

Les paramètres de la zone de collecte 218 sont choisis parmi des paramètres géométriques de la zone de collecte 218 et des paramètres de fonctionnement de la zone de collecte 218 lors du tri dudit au moins un mélange.

Un paramètre géométrique de la zone de collecte 218 est choisi dans la liste constituée de la position des extrémités 234 et 236, la position verticale de la zone de collecte 218, le nombre de diviseurs 240, la position de chaque diviseur 240 et la longueur de chaque diviseur 240.

Selon l'exemple de la figure 3, la position de chaque diviseur 240 est donnée par les coordonnées des points L1 et L2 et la valeur de l'angle (respectivement α et β dans la figure 3) formé par le diviseur 240 et la droite Z1.

La longueur respective de chaque diviseur 240 est notée I1 et I2 sur la figure 3.

Un paramètre de fonctionnement de la zone de collecte 218 lors du tri dudit au moins un mélange est choisi dans la liste constituée de la pureté des granules accumulés dans chaque compartiment 238, la masse des granules accumulés dans chaque compartiment 238, et la charge électrique des granules accumulés dans chaque compartiment 238.

La phase d'optimisation P1 correspond ainsi à une phase de détermination des valeurs d'un jeu de paramètres relatifs à la zone de collecte 218.

Selon l'exemple décrit, la phase d'optimisation P1 comporte une première étape de fourniture E100, une deuxième étape de fourniture E110 et une étape d'optimisation E120.

Lors de la première étape de fourniture E100, il est fourni des valeurs initiales pour les paramètres relatifs au dispositif 210.

Les paramètres relatifs au dispositif 210 sont les paramètres caractérisant (ou relatifs à) chaque partie du dispositif 210.

Dans le présent cas, les paramètres relatifs au dispositif 210 sont les paramètres de la zone de collecte 218, les paramètres relatifs à la zone de tri ZT et un paramètre de fonctionnement du dispositif 210 lors du tri d'un mélange.

Le paramètre relatif à la zone de tri ZT étant choisi dans la liste constituée de la tension des électrodes 220, le positionnement des électrodes 220, la forme des électrodes 220, le nombre de paires d'électrodes 220, la hauteur de chute, le taux d'introduction de granules et le point d'entrée 226 de la zone de tri ZT.

Sur la figure 3, des exemples de paramètres sont représentés. Ainsi, il apparaît que la forme des électrodes 220 est caractérisable par un disque ayant un diamètre D1 ou D2 selon l'électrode 220 considérée et que le positionnement des électrodes 220 est caractérisable par les coordonnées dans le plan (Y, Z) des centres C1 et C2 des électrodes 220.

La hauteur de chute est définie comme la distance entre l'entrée 226 de la chambre de séparation 214 (matérialisée par un point M sur la figure 3) et l'extrémité du diviseur 240 le plus haut selon l'axe d'élévation Z (matérialisée par la ligne en trait mixte Z2 sur la figure 3). Autrement formulée, la hauteur de chute est la distance entre le point M et la ligne Z2. Cette hauteur de chute est notée h.

Le paramètre de fonctionnement du dispositif 210 lors du tri d'un mélange est choisi parmi la tension des électrodes 220, le coefficient de restitution granule/élément dans la zone de tri ZT, le coefficient de friction particule/élément dans la zone de tri ZT et le coefficient de traînée.

Les paramètres de la zone de collecte 218 considérés pour la phase d'optimisation sont les paramètres permettant de fabriquer (ou de régler) la zone de collecte 218. De tels paramètres de fabrication sont appelés dans la suite jeu de paramètres.

Selon l'exemple proposé, la première étape de fourniture est mise en œuvre par réception de données saisies par l'utilisateur du système sur le dispositif d'entrée.

Lors de la deuxième étape de fourniture E110, il est fourni une valeur de performance de tri à respecter par le dispositif 210 lorsqu'au moins un mélange prédéfini est introduit dans le dispositif 210 pour être trié.

Autrement formulé, la valeur de performance est une évaluation de la performance ou de la qualité du fonctionnement du dispositif 210.

De manière générale, le rendement du procédé peut être défini comme la quantité de matière séparée sur la quantité de matière totale introduite dans le séparateur, soit la quantité récupérée dans les compartiments 238 non dédiés à la récupération du mélange (au centre) sur la quantité totale de matière introduite.

Ainsi, par exemple, la valeur de performance de tri est choisie parmi un critère de pureté du mélange obtenu dans un ou plusieurs compartiments 238 de la partie de dispositif 210, un critère de rendement total du dispositif 210, et un critère de rendement du dispositif 210 pour un ou plusieurs matériaux spécifiques.

De préférence, la valeur de performance de tri est évaluée selon une combinaison des critères précédents pour prendre en compte l'importance du couple rendement et pureté pour le présent dispositif 210.

Lors de l'étape d'optimisation E120, il est optimisé une valeur d'au moins un paramètre parmi le jeu de paramètres relatifs à la zone de collecte 218 à l'aide d'une technique d'optimisation.

Plus précisément, la technique comporte l'utilisation d'un modèle associant aux paramètres relatifs au dispositif 210 la performance de tri du dispositif 210 et est mise en œuvre sous la contrainte que le tri effectué par le dispositif 210 présente la valeur de performance de tri fournie.

Cela permet d'obtenir une valeur optimisée pour chaque paramètre optimisé, le jeu de paramètres optimisé étant l'ensemble des valeurs optimisées.

La technique d'optimisation peut comporter l'une des opérations suivantes : le calcul de la trajectoire suivie par chaque granule du au moins un mélange prédéfini, la modélisation de la répartition initiale des charges électriques de chaque matériau du au moins un mélange prédéfini selon une loi gaussienne, la modélisation de la répartition initiale des vitesses de chaque matériau du au moins un mélange prédéfini selon une loi gaussienne, et la modélisation de l'évolution de la position des granules selon une fonction dépendant de la charge électrique des granules accumulés dans chaque compartiment 238 de la partie de dispositif 210.

Plus généralement, la technique d'optimisation utilise sur un modèle reproduisant un mélange binaire de particules chargées dont les équations du mouvement vont être résolues pour chaque particules traversant la zone de tri ZT et atteignant la zone de collecte 218. Les trajectoires vont donc être calculées pour chaque particules ce qui permet de compter les particules tombées dans chaque compartiment 238 de la zone de collecte 218.

A titre d'exemple de modèle, il peut être utilisé une modélisation reposant sur la loi de Newton appliquée à chacune des particules introduite dans le séparateur auquel s'applique les forces suivantes : gravité, force de trainée et force électrique.

Pour calculer la trajectoire d'une seule particule de masse m soumise à la gravité terrestre qui tombe dans un champ électrique E, on résout l'équation donnée par la deuxième loi de Newton, à savoir : ${\sum }_{i} F = m a$

Dans l'expression précédente, les forces de la somme sont au nombre de quatre et sont :
- la gravité qui s'écrit : ***F_{g}*** = *m**g*** ;
- la force de trainée qui s'écrit : ${F}_{d} = \frac{1}{2} {ρ}_{air} {AC}_{d} v \left|v\right|$ avec *A* = *πr*² où r est le rayon de la particule, *ρₐᵢᵣ* la masse volumique de l'air, *C_{d}* le coefficient de trainée et v la vitesse de la particule,
- la force électrique ***F**_{q}* = *q**E*** où E est le vecteur gradient de la tension et q la charge de la particule (en coulomb),

Pour trouver la vitesse u et la position x de la particule, le vecteur d'accélération a est intégré avec la méthode d'Euler. Pour effectuer l'intégration, il faut se donner des valeurs initiales de la vitesse u₀ et de la position x₀.

Le champ électrique est modélisé par l'équation de Laplace selon laquelle le potentiel (équivalent à la tension du système de génération) vérifie : $E = - ∇ ϕ et ϕ = 0$

Pour résoudre cette équation, on s'appuie sur OpenFOAM2 (Open Field Operation And Manipulation), qui est un code open-source.
- La force de contact entre les particules ainsi que les murs et les électrodes 220 est modélisée selon le modèle de Hertz (prise en compte des déformations élastiques de la particule et des surfaces) :
$F = \left({k}_{n}{δn}_{ij}-{γ}_{n}{vn}_{ij}\right) + \left({k}_{t}{δt}_{ij}-{γ}_{t}{vt}_{ij}\right)$

Dans l'expression précédente, la première parenthèse correspond à la force normale, le premier terme étant le recouvrement et le deuxième terme étant la vitesse relative. Similairement, la deuxième parenthèse correspond à la force tangentielle, le premier terme étant le recouvrement et le deuxième terme étant la vitesse relative.

Les notations suivantes sont utilisées :
∘ *δnᵢⱼ* désigne le recouvrement normal entre deux particules,
∘ *kₙ* la constante élastique pour un contact normal,
∘ *γₙ* la constante d'amortissement viscoélastique pour un contact normal,
∘ *vnᵢⱼ* le vecteur déplacement normal entre deux particules sphériques,
∘ *δnᵢⱼ* désigne le recouvrement tangentiel entre deux particules,
∘ *kₙ* la constante élastique pour un contact tangentiel,
∘ *γₙ* la constante d'amortissement viscoélastique pour un contact tangentiel, et
∘ *vnᵢⱼ* le vecteur déplacement tangentiel entre deux particules sphériques.

Dans la technique d'optimisation, une contrainte est que les paramètres relatifs au mélange sont fixes.

En prenant le cas d'un mélange de particules A et B, les paramètres suivants sont maintenus fixes :
- taux d'introduction de particule (ce qui correspond au débit),
- coefficient de restitution particule/particule,
- coefficient de restitution particule/élément dans la zone de tri ZT,
- coefficient de friction particule/particule,
- coefficient de friction particule/élément dans la zone de tri ZT,
- charge électrique des particules A (plus ou moins distribuée selon un modèle gaussien avec une moyenne et un écart-type donné),
- vitesse initiale des particules A (plus ou moins distribué selon un modèle gaussien avec une moyenne et un écart-type donné),
- charge électrique des particules B (plus ou moins distribué selon un modèle gaussien avec une moyenne et un écart-type donné),
- vitesse initiale des particules B (plus ou moins distribué selon un modèle gaussien avec une moyenne et un écart-type donné),
- taille des particules A,
- taille des particules B,
- nombre de particule A,
- nombre de particule B,
- densité des particules A, et
- densité des particules B.

Il est ainsi obtenu une valeur optimisée pour le paramètre.

Selon une variante, la technique d'optimisation est utilisée pour faire varier deux paramètres.

La technique d'optimisation utilise alors une fonction de coût, par exemple donnée par une technique de moindre carré.

Lors de la phase de fabrication, l'unité de fabrication 16 fabrique la zone de collecte 218 présentant les valeurs du jeu de paramètres optimisé.

Alternativement, le procédé comporte une phase de réglage de la zone de collecte 218 pour que la zone de collecte 218 présente les valeurs du jeu de paramètre optimisé.

Dans chacun des cas, la zone de collecte 218 est optimisée à l'utilisation souhaitée et notamment au type de mélange à trier.

Pour cela, le procédé prend des données d'entrées en matière de composition, charge ou taille, simule une séparation, discrétise la zone de collecte 218 en un certain nombre de compartiments 238, détermine la répartition de charge et de masse dans chaque compartiment 238 de la zone de collecte 218 et identifie la combinaison de compartiment(s) 238 approprié(s) en fonction du critère de pureté requis pour chaque matière.

Ce procédé permet donc d'obtenir de meilleur rendement pour le dispositif 210 ainsi obtenu avec une bonne reproductibilité.

Avec des simulations à 10000 particules donnent des résultats reproductibles au dixième de pourcentage près.

Il est à noter que plus la discrétisation de la zone de collecte 218 est fine, plus le rendement augmente.

Cette propriété peut être utilisée en réalisant un affinage de la position idéale du diviseur 240 soit en augmentant le nombre de compartiments 238 simulés, soit en « zoomant » de façon numérique sur la zone d'intérêt. Il est en effet possible de simuler à nouveau le résultat en ne s'intéressant qu'à une fraction de la zone de collecte 218 en définissant la position exacte des compartiments 238.

Avec le procédé, la zone de collecte 218 de la zone de tri ZT peut également être améliorée. L'amélioration pourrait être d'ordre géométrique (dimension, nombre de compartiments 238, forme des diviseurs 240) ou fonctionnelle (plusieurs flux >3). Il est par exemple envisageable de séparer trois matières en une seule étape de tri par triboélectricité. En effet, une connaissance fine des courbes de distribution de charge et de la trajectoire des particules en fonction de leur charge pourrait amener à définir des sous domaines dans la partie de même signe.

Enfin, le procédé peut être décliner selon des formulations alternatives similaires.

A titre d'exemple, l'analyse des résultats de séparation permet de relier la charge massique à la position le long de la zone de collecte 218. Connaissant la vitesse initiale de chaque particule, il peut en être déduit une fonction de déviation, propre à chaque zone de tri ZT, permettant de déterminer la position de sortie en fonction de la charge massique à l'entrée 226.

Ainsi, alternativement, pour obtenir le même résultat, il est possible que le procédé prenne des données d'entrées en matière de composition, charge ou taille, définisse une zone de tri ZT, détermine la fonction de déviation de la zone de tri ZT, tracer les distributions de charge, détermine les domaines associés en fonction du critère de pureté voulu pour chaque matière, paramètre les diviseurs 240 selon la fonction de déviation et simule une séparation dans la zone de tri ZT et vérifier la pertinence des réglages des diviseurs 240.

## Revendications

1. Procédé de conception d'une partie d'un dispositif de séparation électrostatique (210) d'un mélange de granules de matériaux différents, le dispositif (210) comportant une zone de collecte (218) s'étendant entre une première extrémité (234) et une deuxième extrémité (236), la zone de collecte (218) comportant des diviseurs (240) délimitant avec les extrémités (234, 236) des compartiments (238), le dispositif (210) comportant, en outre, une zone de tri, la partie étant la zone de collecte (218) ou la zone de tri, la zone de tri présentant une entrée (226), les granules étant injectés par le haut du dispositif (210) où ils tombent entre deux électrodes (220), les granules chargés positivement étant attirés par l'anode alors que les granules chargés négativement sont attirés par la cathode, les granules ainsi déviés dans leur chute étant séparés et tombant dans des compartiments (238) différents de la zone de collecte (218), disposés en bas du dispositif (210) et au droit des électrodes (220), le dispositif (210) présentant des paramètres relatifs au dispositif (210), les paramètres relatifs au dispositif (210) comprenant les paramètres du jeu de paramètres relatifs à la partie du dispositif (210), le procédé de conception étant mis en œuvre par ordinateur, le procédé comportant une phase d'optimisation des valeurs des paramètres relatifs à la partie du dispositif (210), pour obtenir un jeu de paramètres optimisé, la phase d'optimisation comportant :
- la fourniture d'une valeur de performance de tri à respecter par le dispositif (210) lorsqu'au moins un mélange prédéfini est introduit dans le dispositif (210) pour être trié, la valeur de performance de tri étant choisie parmi :
- un critère de pureté du mélange obtenu dans un ou plusieurs des compartiments (238),
- un critère de rendement total du dispositif (210), et
- un critère de rendement du dispositif (210) pour un ou plusieurs matériaux spécifiques, et
- au moins une optimisation d'une valeur d'au moins un paramètre parmi le jeu de paramètres relatifs à la partie du dispositif (210) à l'aide d'une technique d'optimisation, les paramètres relatifs à la partie du dispositif (210) étant choisis parmi des paramètres géométriques de la zone de collecte (218) et des paramètres de fonctionnement de la zone de collecte (218) lors du tri du mélange, lorsque la partie est la zone de collecte (218), les paramètres géométriques de la zone de collecte (218) étant choisis dans la liste constituée de :
- la position des extrémités (234, 236),
- la position verticale de la zone de collecte (218),
- le nombre de diviseurs (240),
- la position de chaque diviseur (240), et
- la longueur de chaque diviseur (240),
les paramètres de fonctionnement de la zone de collecte (218) lors du tri du mélange étant choisis dans la liste constituée de :
- la pureté des granules accumulés dans chaque compartiment (238),
- la masse des granules accumulés dans chaque compartiment (238), et
- la charge électrique des granules accumulés dans chaque compartiment (238).
ou
lorsque la partie est la zone de tri, le jeu de paramètres du dispositif (210) comportant au moins un paramètre choisi parmi des paramètres relatifs à la zone de tri et des paramètres de fonctionnement dudit dispositif (210) lors du tri du mélange,
les paramètres relatifs à la zone de tri étant choisis dans la liste constituée de :
- la tension des électrodes (220),
- la hauteur de chute, définie comme la distance entre l'entrée (226) de la zone de tri et l'extrémité du diviseur (240) le plus haut selon la direction d'élévation,
- le taux d'introduction de granules,
- le point d'entrée (226) de la zone de tri, et
les paramètres de fonctionnement dudit dispositif (210) lors du tri du mélange étant choisis dans la liste constituée de :
- le coefficient de restitution granule/élément dans la zone de tri,
- le coefficient de friction particule/élément dans la zone de tri, et
- le coefficient de traînée,
la technique d'optimisation comportant l'utilisation d'un modèle associant aux paramètres relatifs au dispositif (210) la performance de tri du dispositif (210) et la technique d'optimisation étant mise en œuvre sous la contrainte que le tri effectué par le dispositif (210) présente la valeur de performance de tri fournie, pour obtenir une valeur optimisée pour chaque paramètre optimisé, le jeu de paramètres optimisé étant l'ensemble des valeurs optimisées,
le modèle comptant les particules tombées dans chaque compartiment de la zone de collecte (218) en résolvant, pour chaque particule d'un mélange binaire de particules chargées, les équations du mouvement de la particule traversant la zone de tri et atteignant la zone de collecte (218) et en calculant la trajectoire de la particule.

2. Procédé selon la revendication 1, dans lequel la technique d'optimisation comporte au moins l'une des opérations suivantes :
- le calcul de la trajectoire suivie par chaque granule du au moins un mélange prédéfini,
- la modélisation de la répartition initiale des charges électriques de chaque matériau du au moins un mélange prédéfini selon une loi gaussienne,
- la modélisation de la répartition initiale des vitesses de chaque matériau du au moins un mélange prédéfini selon une loi gaussienne, et
- la modélisation de l'évolution de la position des granules selon une fonction dépendant de la charge électrique des granules accumulés dans chaque compartiment (238) de la partie de dispositif (210).

3. Procédé selon la revendication 1 ou 2, dans lequel le procédé comporte, en outre, une phase choisie parmi une phase de fabrication de la partie de dispositif (210) présentant les valeurs du jeu de paramètres optimisé et une phase de réglage de la partie de dispositif (210) pour que la partie de dispositif (210) présente les valeurs du jeu de paramètre optimisé.

4. Ensemble de conception propre à concevoir une partie d'un dispositif de séparation électrostatique (210) d'un mélange de granules de matériaux différents, le dispositif présentant des paramètres relatifs au dispositif (210), le dispositif (210) comportant une zone de collecte (218) s'étendant entre une première extrémité (234) et une deuxième extrémité (236), la zone de collecte (218) comportant des diviseurs (240) délimitant avec les extrémités (234, 236) des compartiments (238), le dispositif (210) comportant, en outre, une zone de tri, la partie étant la zone de collecte (218) ou la zone de tri, la zone de tri présentant une entrée (226), les granules étant injectés par le haut du dispositif (210) où ils tombent entre deux électrodes (220), les granules chargés positivement étant attirés par l'anode alors que les granules chargés négativement sont attirés par la cathode, les granules ainsi déviés dans leur chute étant séparés et tombant dans des compartiments (238) différents de la zone de collecte (218), disposés en bas du dispositif (210) et au droit des électrodes (220), les paramètres relatifs au dispositif (210) comprenant les paramètres du jeu de paramètres relatifs à la partie du dispositif (210), l'ensemble de conception comportant :
- un système propre à optimiser des valeurs d'un jeu de paramètres relatifs à la partie du dispositif (210) pour obtenir un jeu de paramètres optimisé en interaction avec un produit programme d'ordinateur, le système étant propre à :
- recevoir une valeur de performance de tri à respecter par le dispositif (210) lorsqu'au moins un mélange prédéfini est introduit dans le dispositif (210) pour être trié, la valeur de performance de tri étant choisie parmi :
- un critère de pureté du mélange obtenu dans un ou plusieurs des compartiments (238),
- un critère de rendement total du dispositif (210), et
- un critère de rendement du dispositif (210) pour un ou plusieurs matériaux spécifiques,
- optimiser une valeur d'au moins un paramètre parmi le jeu de paramètres relatifs à la partie du dispositif (210) à l'aide d'une technique d'optimisation,
les paramètres relatifs à la partie du dispositif (210) étant choisis parmi des paramètres géométriques de la zone de collecte (218) et des paramètres de fonctionnement de la zone de collecte (218) lors du tri du mélange, lorsque la partie est la zone de collecte (218), les paramètres géométriques de la zone de collecte (218) étant choisis dans la liste constituée de :
- la position des extrémités (234, 236),
- la position verticale de la zone de collecte (218),
- le nombre de diviseurs (240),
- la position de chaque diviseur (240), et
- la longueur de chaque diviseur (240),
les paramètres de fonctionnement de la zone de collecte (218) lors du tri du mélange étant choisis dans la liste constituée de :
- la pureté des granules accumulés dans chaque compartiment (238),
- la masse des granules accumulés dans chaque compartiment (238), et
- la charge électrique des granules accumulés dans chaque compartiment (238).
ou
lorsque la partie est la zone de tri, le jeu de paramètres du dispositif (210) comportant au moins un paramètre choisi parmi des paramètres relatifs à la zone de tri et des paramètres de fonctionnement dudit dispositif (210) lors du tri du mélange,
les paramètres relatifs à la zone de tri étant choisis dans la liste constituée de :
- la tension des électrodes (220),
- la hauteur de chute, définie comme la distance entre l'entrée (226) de la zone de tri et l'extrémité du diviseur (240) le plus haut selon la direction d'élévation,
- le taux d'introduction de granules,
- le point d'entrée (226) de la zone de tri, et
les paramètres de fonctionnement dudit dispositif (210) lors du tri du mélange étant choisis dans la liste constituée de :
- le coefficient de restitution granule/élément dans la zone de tri,
- le coefficient de friction particule/élément dans la zone de tri, et
- le coefficient de traînée,
la technique d'optimisation comportant l'utilisation d'un modèle associant aux paramètres relatifs au dispositif (210) la performance de tri du dispositif (210) et la technique d'optimisation étant mise en œuvre sous la contrainte que le tri effectué par le dispositif (210) présente la valeur de performance de tri fournie, pour obtenir une valeur optimisée pour chaque paramètre optimisé, le jeu de paramètres optimisé étant l'ensemble des valeurs optimisées, et
- une unité choisie parmi une unité de fabrication propre à fabriquer la partie de dispositif (210) présentant les valeurs du jeu de paramètre optimisé et une unité de réglage propre à régler la partie de dispositif (210) pour que la partie de dispositif (210) présente les valeurs du jeu de paramètre optimisé,
le modèle comptant les particules tombées dans chaque compartiment de la zone de collecte (218) en résolvant, pour chaque particule d'un mélange binaire de particules chargées, les équations du mouvement de la particule traversant la zone de tri et atteignant la zone de collecte (218) et en calculant la trajectoire de la particule.

## Patentansprüche

1. Verfahren zur Auslegung eines Teils einer Vorrichtung zur elektrostatischen Trennung (210) eines Gemischs aus Granulatkörnern unterschiedlicher Materialien, wobei die Vorrichtung (210) eine Sammelzone (218) aufweist, die sich zwischen einem ersten Ende (234) und einem zweiten Ende (236) erstreckt, wobei die Sammelzone (218) Teiler (240) aufweist, die zusammen mit den Enden (234, 236) Fächer (238) begrenzen, wobei die Vorrichtung (210) ferner eine Sortierzone aufweist, wobei der Teil die Sammelzone (218) oder die Sortierzone ist, wobei die Sortierzone einen Eingang (226) aufweist, wobei die Granulatkörner von oben in die Vorrichtung (210) eingespritzt werden, wo sie zwischen zwei Elektroden (220) fallen, wobei die positiv geladenen Granulatkörner von der Anode angezogen werden, während die negativ geladenen Granulatkörner von der Kathode angezogen werden, wobei die auf diese Weise in ihrem Fall abgelenkten Granulatkörner getrennt werden und in verschiedene Fächer (238) der Sammelzone (218) fallen, die am Boden der Vorrichtung (210) und lotrecht zu den Elektroden (220) angeordnet sind, wobei die Vorrichtung (210) vorrichtungsbezogene Parameter aufweist, wobei die vorrichtungsbezogenen Parameter die Parameter des Parametersatzes bezüglich des Teils der Vorrichtung (210) umfassen, wobei das Auslegungsverfahren computerimplementiert ist, wobei das Verfahren eine Phase der Optimierung der Werte der Parameter bezüglich des Teils der Vorrichtung (210) umfasst, um einen optimierten Parametersatz zu erhalten, wobei die Optimierungsphase umfasst:
- die Bereitstellung eines von der Vorrichtung (210) einzuhaltenden Sortierleistungswerts, wenn mindestens ein vordefiniertes Gemisch in die Vorrichtung (210) eingebracht wird, um sortiert zu werden, wobei der Sortierleistungswert ausgewählt ist aus:
- einem Reinheitskriterium des in einem oder mehreren der Fächer (238) erhaltenen Gemischs,
- einem Kriterium für die Gesamtausbeute der Vorrichtung (210), und
- einem Kriterium für die Ausbeute der Vorrichtung (210) für ein oder mehrere spezifische Materialien, und
- mindestens eine Optimierung eines Werts mindestens eines Parameters aus dem Parametersatz bezüglich des Teils der Vorrichtung (210) unter Verwendung einer Optimierungstechnik,
wobei die Parameter bezüglich des Teils der Vorrichtung (210) ausgewählt sind aus geometrischen Parametern der Sammelzone (218) und Betriebsparametern der Sammelzone (218) beim Sortieren des Gemischs, wenn der Teil die Sammelzone (218) ist, wobei die geometrischen Parameter der Sammelzone (218) aus der Liste ausgewählt sind, die aus Folgendem besteht:
- der Position der Enden (234, 236),
- der vertikalen Position der Sammelzone (218),
- der Anzahl der Teiler (240),
- der Position jedes Teilers (240), und
- der Länge jedes Teilers (240),
wobei die Betriebsparameter der Sammelzone (218) beim Sortieren des Gemischs aus der Liste ausgewählt sind, die aus Folgendem besteht:
- der Reinheit der in jedem Fach (238) angesammelten Granulatkörner,
- der Masse der in jedem Fach (238) angesammelten Granulatkörner, und
- der elektrischen Ladung der in jedem Fach (238) angesammelten Granulatkörner.
oder
wenn der Teil die Sortierzone ist, wobei der Parametersatz der Vorrichtung (210) mindestens einen Parameter umfasst, der aus Parametern bezüglich der Sortierzone und Betriebsparametern der Vorrichtung (210) beim Sortieren des Gemischs ausgewählt ist,
wobei die Parameter bezüglich der Sortierzone aus der Liste ausgewählt sind, die aus Folgendem besteht:
- der Spannung der Elektroden (220),
- der Fallhöhe, definiert als der Abstand zwischen dem Eingang (226) der Sortierzone und dem Ende des Teilers (240), der gemäß der Erhebungsrichtung am höchsten liegt,
- der Einführungsrate von Granulatkörnern,
- dem Eintrittspunkt (226) der Sortierzone, und
wobei die Betriebsparameter der Vorrichtung (210) beim Sortieren des Gemischs aus der Liste ausgewählt sind, die aus Folgendem besteht:
- dem Rückprallkoeffizienten Granulatkorn/Element in der Sortierzone,
- dem Reibungskoeffizienten Partikel/Element in der Sortierzone, und
- dem Widerstandskoeffizienten,
wobei die Optimierungstechnik die Verwendung eines Modells umfasst, das die Parameter bezüglich der Vorrichtung (210) mit der Sortierleistung der Vorrichtung (210) verknüpft, und wobei die Optimierungstechnik unter der Bedingung implementiert wird, dass die durch die Vorrichtung (210) durchgeführte Sortierung den bereitgestellten Sortierleistungswert aufweist, um für jeden optimierten Parameter einen optimierten Wert zu erhalten, wobei der optimierte Parametersatz die Gesamtheit der optimierten Werte ist,
wobei das Modell die in jedes Fach der Sammelzone (218) gefallenen Partikel zählt, indem es für jedes Partikel eines binären Gemischs geladener Partikel die Bewegungsgleichungen des Partikels löst, das die Sortierzone durchquert und die Sammelzone (218) erreicht, und indem es die Flugbahn des Partikels berechnet.

2. Verfahren nach Anspruch 1, wobei die Optimierungstechnik mindestens einen der folgenden Vorgänge umfasst:
- die Berechnung der von jedem Granulatkorn des mindestens einen vordefinierten Gemischs zurückgelegten Flugbahn,
- die Modellierung der anfänglichen Verteilung der elektrischen Ladungen jedes Materials des mindestens einen vordefinierten Gemischs gemäß einem Gaußschen Gesetz,
- die Modellierung der anfänglichen Verteilung der Geschwindigkeiten jedes Materials des mindestens einen vordefinierten Gemischs gemäß einem Gaußschen Gesetz, und
- die Modellierung der Entwicklung der Position der Granulate gemäß einer Funktion, die von der elektrischen Ladung der in jedem Abteil (238) des Vorrichtungsteils (210) angesammelten Granulate abhängt.

3. Verfahren nach Anspruch 1 oder 2, wobei das Verfahren ferner eine Phase umfasst, die aus einer Phase der Herstellung des Vorrichtungsteils (210), das die Werte des optimierten Parametersatzes aufweist, und einer Phase der Einstellung des Vorrichtungsteils (210), damit der Vorrichtungsteil (210) die Werte des optimierten Parametersatzes aufweist, ausgewählt ist.

4. Auslegungssystem, das dazu geeignet ist, einen Teil einer elektrostatischen Trennvorrichtung (210) eines Gemischs aus Granulaten unterschiedlicher Materialien auszulegen, wobei die Vorrichtung Parameter aufweist, die sich auf die Vorrichtung (210) beziehen, wobei die Vorrichtung (210) einen Sammelbereich (218) umfasst, der sich zwischen einem ersten Ende (234) und einem zweiten Ende (236) erstreckt, wobei der Sammelbereich (218) Teiler (240) umfasst, die mit den Enden (234, 236) Abteile (238) begrenzen, wobei die Vorrichtung (210) ferner einen Sortierbereich umfasst, wobei der Teil der Sammelbereich (218) oder der Sortierbereich ist, wobei der Sortierbereich einen Eingang (226) aufweist, wobei die Granulate von oben in die Vorrichtung (210) eingespritzt werden, wo sie zwischen zwei Elektroden (220) fallen, wobei die positiv geladenen Granulate von der Anode angezogen werden, während die negativ geladenen Granulate von der Kathode angezogen werden, wobei die somit in ihrem Fall abgelenkten Granulate getrennt werden und in verschiedene Abteile (238) des Sammelbereichs (218) fallen, die unten in der Vorrichtung (210) und auf Höhe der Elektroden (220) angeordnet sind, wobei die sich auf die Vorrichtung (210) beziehenden Parameter die Parameter des Parametersatzes umfassen, die sich auf den Teil der Vorrichtung (210) beziehen, wobei das Auslegungssystem umfasst:
- ein System, das dazu geeignet ist, Werte eines Parametersatzes, der sich auf den Teil der Vorrichtung (210) bezieht, zu optimieren, um einen optimierten Parametersatz in Wechselwirkung mit einem Computerprogrammprodukt zu erhalten, wobei das System dazu geeignet ist:
- einen von der Vorrichtung (210) einzuhaltenden Wert der Sortierleistung zu empfangen, wenn mindestens ein vordefiniertes Gemisch in die Vorrichtung (210) eingebracht wird, um sortiert zu werden, wobei der Wert der Sortierleistung aus Folgendem ausgewählt ist:
- ein Reinheitskriterium des in einem oder mehreren der Abteile (238) erhaltenen Gemischs,
- ein Kriterium des Gesamtertrags der Vorrichtung (210), und
- ein Kriterium des Ertrags der Vorrichtung (210) für ein oder mehrere spezifische Materialien,
- einen Wert mindestens eines Parameters aus dem Parametersatz, der sich auf den Teil der Vorrichtung (210) bezieht, mithilfe einer Optimierungstechnik zu optimieren,
wobei die sich auf den Teil der Vorrichtung (210) beziehenden Parameter aus geometrischen Parametern des Sammelbereichs (218) und Betriebsparametern des Sammelbereichs (218) beim Sortieren des Gemischs ausgewählt sind, wenn der Teil der Sammelbereich (218) ist, wobei die geometrischen Parameter des Sammelbereichs (218) aus der Liste ausgewählt sind, die aus Folgendem besteht:
- der Position der Enden (234, 236),
- der vertikalen Position des Sammelbereichs (218),
- der Anzahl der Teiler (240),
- der Position jedes Teilers (240), und
- der Länge jedes Teilers (240),
wobei die Betriebsparameter des Sammelbereichs (218) beim Sortieren des Gemischs aus der Liste ausgewählt sind, die aus Folgendem besteht:
- der Reinheit der in jedem Abteil (238) angesammelten Granulate,
- der Masse der in jedem Abteil (238) angesammelten Granulate, und
- der elektrischen Ladung der in jedem Abteil (238) angesammelten Granulate.
oder
wenn der Teil der Sortierbereich ist, wobei der Parametersatz der Vorrichtung (210) mindestens einen Parameter umfasst, der aus Parametern, die sich auf den Sortierbereich beziehen, und Betriebsparametern der genannten Vorrichtung (210) beim Sortieren des Gemischs ausgewählt ist,
wobei die sich auf den Sortierbereich beziehenden Parameter aus der Liste ausgewählt sind, die aus Folgendem besteht:
- der Spannung der Elektroden (220),
- der Fallhöhe, definiert als der Abstand zwischen dem Eingang (226) des Sortierbereichs und dem Ende des in der Erhebungsrichtung höchsten Teilers (240),
- der Einführungsrate von Granulaten,
- dem Eintrittspunkt (226) des Sortierbereichs, und
wobei die Betriebsparameter der genannten Vorrichtung (210) beim Sortieren des Gemischs aus der Liste ausgewählt sind, die aus Folgendem besteht:
- dem Rückprallkoeffizienten Granulat/Element im Sortierbereich,
- dem Reibungskoeffizienten Partikel/Element im Sortierbereich, und
- dem Schleppkoeffizienten,
die Optimierungstechnik umfassend die Verwendung eines Modells, das den die Vorrichtung (210) betreffenden Parametern die Sortierleistung der Vorrichtung (210) zuordnet, und wobei die Optimierungstechnik unter der Randbedingung umgesetzt wird, dass die durch die Vorrichtung (210) durchgeführte Sortierung den bereitgestellten Sortierleistungswert aufweist, um für jeden optimierten Parameter einen optimierten Wert zu erhalten, wobei der optimierte Parametersatz die Gesamtheit der optimierten Werte ist, und
- eine Einheit, die aus einer Herstellungseinheit, die dazu geeignet ist, den Vorrichtungsteil (210) herzustellen, der die Werte des optimierten Parametersatzes aufweist, und einer Einstelleinheit, die dazu geeignet ist, den Vorrichtungsteil (210) so einzustellen, dass der Vorrichtungsteil (210) die Werte des optimierten Parametersatzes aufweist, ausgewählt ist,
wobei das Modell, das die in jedes Fach der Sammelzone (218) gefallenen Partikel zählt, indem es für jedes Partikel eines binären Gemischs geladener Partikel die Bewegungsgleichungen des Partikels löst, das die Sortierzone durchquert und die Sammelzone (218) erreicht, und die Flugbahn des Partikels berechnet.

## Claims

1. Method for designing a part of an electrostatic separation device (210) for a mixture of granules of different materials, the device (210) comprising a collection zone (218) extending between a first end (234) and a second end (236), the collection zone (218) comprising dividers (240) delimiting, with the ends (234, 236), compartments (238), the device (210) further comprising a sorting zone, the part being the collection zone (218) or the sorting zone, the sorting zone having an inlet (226), the granules being injected from the top of the device (210) where they fall between two electrodes (220), the positively charged granules being attracted by the anode whereas the negatively charged granules are attracted by the cathode, the granules thus deflected in their fall being separated and falling into different compartments (238) of the collection zone (218), arranged at the bottom of the device (210) and opposite the electrodes (220), the device (210) having parameters relating to the device (210), the parameters relating to the device (210) comprising the parameters of the set of parameters relating to the part of the device (210), the design method being computer-implemented, the method comprising a phase of optimizing the values of the parameters relating to the part of the device (210), to obtain an optimized set of parameters, the optimization phase comprising:
- providing a sorting performance value to be complied with by the device (210) when at least one predefined mixture is introduced into the device (210) to be sorted, the sorting performance value being selected from:
- a purity criterion of the mixture obtained in one or more of the compartments (238),
- a criterion of overall yield of the device (210), and
- a criterion of yield of the device (210) for one or more specific materials, and
- at least one optimization of a value of at least one parameter among the set of parameters relating to the part of the device (210) using an optimization technique,
the parameters relating to the part of the device (210) being selected from geometrical parameters of the collection zone (218) and operating parameters of the collection zone (218) during sorting of the mixture, when the part is the collection zone (218), the geometrical parameters of the collection zone (218) being selected from the list consisting of:
- the position of the ends (234, 236),
- the vertical position of the collection zone (218),
- the number of dividers (240),
- the position of each divider (240), and
- the length of each divider (240),
the operating parameters of the collection zone (218) during sorting of the mixture being selected from the list consisting of:
- the purity of the granules accumulated in each compartment (238),
- the mass of the granules accumulated in each compartment (238), and
- the electric charge of the granules accumulated in each compartment (238). or
when the part is the sorting zone, the set of parameters of the device (210) comprising at least one parameter selected from parameters relating to the sorting zone and operating parameters of said device (210) during sorting of the mixture,
the parameters relating to the sorting zone being selected from the list consisting of:
- the voltage of the electrodes (220),
- the drop height, defined as the distance between the inlet (226) of the sorting zone and the end of the uppermost divider (240) in the elevation direction,
- the granule introduction rate,
- the inlet point (226) of the sorting zone, and
the operating parameters of said device (210) during sorting of the mixture being selected from the list consisting of:
- the granule/component coefficient of restitution in the sorting zone,
- the particle/component coefficient of friction in the sorting zone, and
- the drag coefficient,
the optimization technique comprising the use of a model associating the parameters relating to the device (210) with the sorting performance of the device (210) and the optimization technique being implemented under the constraint that the sorting performed by the device (210) has the provided sorting performance value, in order to obtain an optimized value for each optimized parameter, the optimized set of parameters being the set of optimized values, the model counting the particles falling into each compartment of the collection zone (218) by solving, for each particle of a binary mixture of charged particles, the equations of motion of the particle passing through the sorting zone and reaching the collection zone (218) and by calculating the trajectory of the particle.

2. Method according to claim 1, wherein the optimization technique comprises at least one of the following operations:
- calculating the trajectory followed by each granule of the at least one predefined mixture,
- modelling the initial distribution of the electric charges of each material of the at least one predefined mixture according to a Gaussian law,
- modelling the initial distribution of the velocities of each material of the at least one predefined mixture according to a Gaussian law, and
- modelling the evolution of the position of the granules according to a function dependent on the electric charge of the granules accumulated in each compartment (238) of the part of the device (210).

3. Method according to claim 1 or 2, wherein the method further comprises a phase selected from a phase of manufacturing the part of the device (210) having the values of the optimized set of parameters and a phase of adjusting the part of the device (210) so that the part of the device (210) has the values of the optimized set of parameter.

4. Design assembly suitable for designing a part of an electrostatic separation device (210) for a mixture of granules of different materials, the device having parameters relating to the device (210), the device (210) comprising a collection zone (218) extending between a first end (234) and a second end (236), the collection zone (218) comprising dividers (240) delimiting, with the ends (234, 236), compartments (238), the device (210) further comprising a sorting zone, the part being the collection zone (218) or the sorting zone, the sorting zone having an inlet (226), the granules being injected from the top of the device (210) where they fall between two electrodes (220), the positively charged granules being attracted by the anode whereas the negatively charged granules are attracted by the cathode, the granules thus deflected during their fall being separated and falling into different compartments (238) of the collection zone (218), arranged at the bottom of the device (210) and opposite the electrodes (220), the parameters relating to the device (210) comprising the parameters of the set of parameters relating to the part of the device (210), the design assembly comprising:
- a system suitable for optimizing values of a set of parameters relating to the part of the device (210) in order to obtain an optimized set of parameters in interaction with a computer program product, the system being suitable for:
- receiving a sorting performance value to be complied with by the device (210) when at least one predefined mixture is introduced into the device (210) to be sorted, the sorting performance value being selected from:
- a purity criterion of the mixture obtained in one or more of the compartments (238),
- a total yield criterion of the device (210), and
- a yield criterion of the device (210) for one or more specific materials,
- optimizing a value of at least one parameter from among the set of parameters relating to the portion of the device (210) using an optimization technique,
the parameters relating to the portion of the device (210) being selected from among geometrical parameters of the collection zone (218) and operating parameters of the collection zone (218) during sorting of the mixture, when the portion is the collection zone (218), the geometrical parameters of the collection zone (218) being selected from the list consisting of:
- the position of the ends (234, 236),
- the vertical position of the collection zone (218),
- the number of dividers (240),
- the position of each divider (240), and
- the length of each divider (240),
the operating parameters of the collection zone (218) during sorting of the mixture being selected from the list consisting of:
- the purity of the granules accumulated in each compartment (238),
- the mass of the granules accumulated in each compartment (238), and
- the electric charge of the granules accumulated in each compartment (238).or
when the portion is the sorting zone, the set of parameters of the device (210) comprising at least one parameter selected from among parameters relating to the sorting zone and operating parameters of said device (210) during sorting of the mixture,
the parameters relating to the sorting zone being selected from the list consisting of:
- the voltage of the electrodes (220),
- the drop height, defined as the distance between the inlet (226) of the sorting zone and the end of the highest divider (240) in the elevation direction,
- the rate of introduction of granules,
- the inlet point (226) of the sorting zone, and
the operating parameters of said device (210) during sorting of the mixture being selected from the list consisting of:
- the granule/element coefficient of restitution in the sorting zone,
- the particle/element coefficient of friction in the sorting zone, and
- the drag coefficient,
the optimization technique comprising the use of a model associating the sorting performance of the device (210) with the parameters relating to the device (210), and the optimization technique being implemented under the constraint that the sorting carried out by the device (210) has the supplied sorting performance value, in order to obtain an optimized value for each optimized parameter, the optimized set of parameters being the set of optimized values, and
- a unit selected from among a manufacturing unit configured to manufacture the device portion (210) having the values of the optimized parameter set and an adjustment unit configured to adjust the device portion (210) such that the device portion (210) has the values of the optimized parameter set,
the model counting the particles fallen into each compartment of the collection zone (218) by solving, for each particle of a binary mixture of charged particles, the equations of motion of the particle passing through the sorting zone and reaching the collection zone (218) and by calculating the trajectory of the particle
